# EUROPEAN PATENT APPLICATION

(11) **EP 4 084 087 A1**
(43) Date of publication of application: **02.11.2022**
(21) Application number: 21909538.7
(22) Date of filing: 23.12.2021
(51) Int. Cl.: H01L 31/0224

(54) **PERC SOLAR CELL SELECTIVE EMITTER, PERC SOLAR CELL AND MANUFACTURING METHOD THEREFOR**

(30) Priority: 25.12.2020 CN 202011573167
(71) Applicant: Tongwei Solar (Chengdu) Co., Ltd., Chengdu, Sichuan 610299 (CN)
(72) Inventor: SUI, Shan, Chengdu, Sichuan 610299 (CN); HE, Yu, Chengdu, Sichuan 610299 (CN); WANG, Lan, Chengdu, Sichuan 610299 (CN); LI, Zhongyong, Chengdu, Sichuan 610299 (CN); SU, Rong, Chengdu, Sichuan 610299 (CN); WANG, Pu, Chengdu, Sichuan 610299 (CN); XIE, Yi, Chengdu, Sichuan 610299 (CN)
(74) Representative: Papa, Elisabetta
(86) International application number: PCT/CN2021/140975
(87) International publication number: WO 2022/135543

(57) **Abstract**

The present application relates to the field of solar cells, and provides a PERC solar cell selective emitter, a PERC solar cell and a manufacturing method therefor. The selective emitter comprises a silicon wafer and first lightly doped regions, second lightly doped regions and a laser heavily doped region; the laser heavily doped region comprises a plurality of doped layers; each doped layer comprises a plurality of doped regions arranged at intervals; the first lightly doped regions are located between the doped regions of each doped layer, and each second lightly doped region is located between two adjacent doped layers. The PERC solar cell comprises the selective emitter, a front anti-reflective layer on the surface of a front passivation layer, and a positive electrode. The positive electrode comprises first silver paste layers on the surfaces of the laser heavily doped regions and second silver paste layers on the surface of the front anti-reflective layer corresponding to the first lightly doped regions, and the second silver paste layers are in electrical contact with the first silver paste layers. Damage of laser to silicon wafers is reduced, compounding in silver paste areas is reduced, an open circuit voltage is increased, and the battery efficiency is improved.

## Description

### Cross-reference to Related Applications

The present application claims priority to Chinese Patent Application No. 202011573167.9, entitled "PERC Solar Cell Selective Emitter, PERC Solar Cell and Manufacturing Method Therefor", filed with China National Intellectual Property Administration on December 25, 2020, the entire content of which is incorporated herein by reference.

### Technical Field

The present application relates to the field of solar cells, and particularly to a PERC solar cell selective emitter, a PERC solar cell and a manufacturing method therefor.

### Background Art

In the manufacturing process of a solar cell, a selective emitter with a heavily doped region and a lightly doped region may be formed on the surface of a silicon wafer using a laser doping technology. However, in the laser doping process, the silicon wafer may be damaged by the sharp thermal action of laser, and the laser action position has serious compounding, which influences an open circuit voltage of the cell, and meanwhile damages the textured structure of the front surface and reduces absorption of a current, thus affecting an improvement of the cell efficiency.

### Summary

The present application provides a PERC solar cell selective emitter, a PERC solar cell and a manufacturing method therefor, which may reduce damage of laser to a silicon wafer and improve the cell efficiency.

Some embodiments of the present application provide a PERC solar cell selective emitter, which may include: a silicon wafer and first lightly doped regions, second lightly doped regions and a laser heavily doped region on the front surface of the silicon wafer; the laser heavily doped region includes a plurality of doped layers arranged at intervals in a preset direction; each doped layer includes a plurality of doped regions arranged at intervals; the first lightly doped regions are located between the doped regions of each doped layer, and each second lightly doped region is located between two adjacent doped layers.

Optionally, the laser heavily doped region and the first lightly doped region may have a total area of S, and the area of the laser heavily doped region and S may have a ratio of 1:10 to 9:10.

Optionally, the area of the laser heavily doped region and S may have a ratio of 2:5 to 3:5.

Optionally, the doped regions of two adjacent doped layers may be staggered.

Optionally, the silicon wafer may have a resistivity of 0.1Ω*cm to 3.0Ω*cm.

Further embodiments of the present application provide a PERC solar cell, which may include: a PERC solar cell selective emitter according to some embodiments of the present application, a front passivation layer on the surfaces of the first lightly doped region and the second lightly doped region, a front anti-reflective layer on the surface of the front passivation layer, and a positive electrode.

The positive electrode includes first silver paste layers on the surfaces of the laser heavily doped regions and second silver paste layers on the surface of the front anti-reflective layer corresponding to the first lightly doped regions, and the second silver paste layers are in electrical contact with the first silver paste layers.

Optionally, the front anti-reflective layer may be a silicon nitride layer, and the front passivation layer may be a silicon dioxide layer.

Optionally, the back surface of the PERC solar cell may be further provided with a back passivation layer and an aluminum back surface field, the back passivation layer may be formed on the back surface of the silicon wafer, the back passivation layer may be provided with a slot, and the aluminum back surface field may be formed on the surface of the back passivation layer and in the slot and in contact with the back surface of the silicon wafer.

Still further embodiments of the present application provide a manufacturing method for a PERC solar cell according to further embodiments of the present application, which may include:
diffusing on the surface of the textured silicon wafer to form a diffusion layer, and performing laser doping on the diffusion layer to form the laser heavily doped region, regions of the diffusion layer which are not subjected to laser doping being lightly doped regions, and the lightly doped regions including the first lightly doped region and the second lightly doped region;
sequentially plating the surfaces of the laser heavily doped region and the lightly doped region with the front passivation layer and the front anti-reflective layer; and
plating the surface of the front anti-reflective layer corresponding to the laser heavily doped region with the first silver paste layer, and burning through the front anti-reflective layer and the front passivation layer, such that the first silver paste layer is in contact with the laser heavily doped region, and plating the surface of the front anti-reflective layer corresponding to the first lightly doped region with the second silver paste layer, the second silver paste layer being in electrical contact with the first silver paste layer.

Optionally, the back passivation layer is formed on the back surface of the silicon wafer, the back passivation layer is slotted, the aluminum back surface field is formed on the surface of the back passivation layer and in the slot, and the aluminum back surface field is in contact with the back surface of the silicon wafer.

Optionally, paste of the first silver paste layer may contain 5wt% to 10wt% of oxide, paste of the second silver paste layer may contain 0wt% to 2wt% of oxide, and the oxide may include at least one of PbO, B₂O₃, SiO₂, BiO₃, and ZnO.

Optionally, the paste of the first silver paste layer and the paste of the second silver paste layer may each contain 60wt% to 90wt% of silver powder.

Optionally, the silver powder may have a particle size of 0.1µm to 4µm.

Optionally, the paste of the first silver paste layer and the paste of the second silver paste layer may further contain organic carriers, and the organic carriers may include a thickener, a solvent, a surfactant, and a thixotropic agent.

Optionally, the paste of the first silver paste layer and the paste of the second silver paste layer may contain 10wt% to 30wt% of organic carriers.

The PERC solar cell selective emitter, the PERC solar cell and the manufacturing method therefor according to the embodiments of the present application at least have the beneficial effects as follows.

The laser heavily doped region of the PERC solar cell is a laser processed part, the first and second lightly doped regions are parts which are not processed by laser, the first lightly doped region is located between the doped regions of each doped layer, the first silver paste layer may burn through the front anti-reflective layer and the front passivation layer to be in contact with the laser heavily doped region to form good ohmic contact, the second silver paste layer does not burn through the front anti-reflective layer and the front passivation layer to be formed on the surface of the front anti-reflective layer corresponding to the first lightly doped region, and the second silver paste layer is in electrical contact with the first silver paste layer to achieve effects of connection and current leading-out. Compared with the solution that the doped regions are continuously arranged, in the embodiments of the present application, laser doped regions are relatively small, thus reducing damage of laser to the silicon wafer, and reducing surface compounding of the silicon wafer and damage of the laser to a textured surface. When the doped regions are continuously arranged, the silver paste layer is required to burn through the front passivation layer to be in contact with the silicon wafer; compared with the solution that the silver paste layer is in complete contact with the silicon wafer, in the embodiments of the present application, the second silver paste layer is only in contact with the first silver paste layer and not in contact with the silicon wafer, resulting in low series resistance. The arrangement of the laser heavily doped region and the arrangement of the first and second silver paste layers of the PERC solar cell according to the embodiments of the present application improve the cell efficiency.

### Brief Description of Drawings

To describe the technical solutions in the embodiments of the present application more clearly, the following briefly describes the accompanying drawings required in the embodiments. It should be understood that the following accompanying drawings show merely some embodiments of the present application and therefore should not be considered as limiting the scope, and a person of ordinary skill in the art may still derive other related drawings from these accompanying drawings without creative efforts.
FIG. 1 is a schematic structural diagram of a PERC solar cell selective emitter according to an embodiment of the present application;
FIG. 2 is a schematic diagram of an arrangement position of a heavily doped region, a first lightly doped region and a second lightly doped region in the embodiment of the present application;
FIG. 3 is a schematic diagram of another arrangement position of the heavily doped region, the first lightly doped region and the second lightly doped region in the embodiment of the present application;
FIG. 4 is a schematic structural diagram of a PERC solar cell according to an embodiment of the present application;
FIG. 5 shows a structure obtained after step S2 of a manufacturing method for a PERC solar cell according to an embodiment of the present application; and
FIG. 6 shows a structure obtained after step S3 of the manufacturing method for a PERC solar cell according to the embodiment of the present application.

Reference numerals: 100-selective emitter; 10-PERC solar cell; 11-silicon wafer; 12-diffusion layer; 121-first lightly doped region; 122-second lightly doped region; 13-heavily doped region; 131-doped layer; 1311-doped region; 14-front passivation layer; 15-front anti-reflective layer; 161-first silver paste layer; 162-second silver paste layer; 17-back passivation layer; 171-back silicon nitride layer; 172-back aluminum oxide layer; 18-aluminum back surface field.

### Detailed Description of Embodiments

The implementation of the present application will be described in detail below in conjunction with embodiments, but those skilled in the art would understand that the following embodiments are merely for illustrating the present application and should not be deemed as restriction of the present application. The embodiments in which specific conditions are not given are performed according to conventional conditions or conditions suggested by manufacturers. The reagents or instruments used in the present invention, the manufacturers of which are not indicated, are the commercially available conventional products.

In the manufacturing process of a solar cell, when a heavily doped region and a lightly doped region are formed on the surface of a silicon wafer using laser doping, the silicon wafer is prone to damage by the laser, and the cell efficiency tends to be influenced. The applicant finds through research that generally, continuous laser spots are adopted to perform laser doping on the position corresponding to a grid line region to form a heavily doped region, and during subsequent silver paste printing, in order to lead out a current, a silver paste layer is generally in contact with the whole doped region of the silicon wafer, resulting in large contact resistance. When researching this treatment mode, the applicant finds that since the laser spots for laser doping are continuous, the laser has large damage to the silicon wafer and a textured surface, current absorption may be reduced simultaneously, surface compounding of the silicon wafer is high, and an open circuit voltage of the cell is affected, which influences the cell efficiency; in addition, this treatment mode may cause large contact resistance, which also affects the cell efficiency.

Based on this, embodiments of the present application provide a PERC solar cell selective emitter 100, a PERC solar cell 10 and a manufacturing method therefor, which may reduce damage of laser to a silicon wafer 11 and improve the cell efficiency.

The PERC solar cell selective emitter 100, the PERC solar cell 10 and the manufacturing method therefor according to the embodiments of the present application are described specifically below.

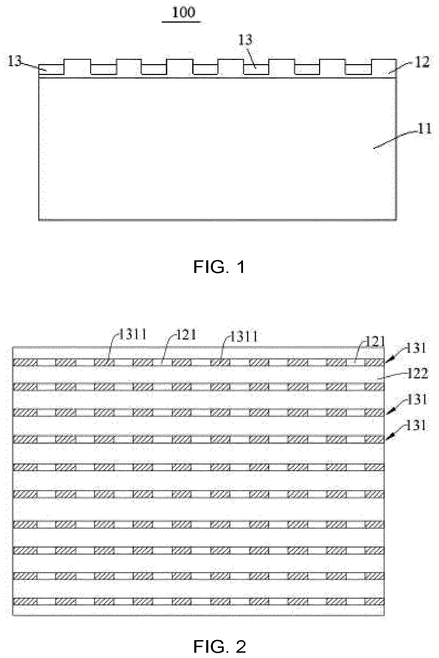

Some embodiments of the present application provide a PERC solar cell selective emitter 100, which may include: a silicon wafer 11 and first lightly doped regions 121, second lightly doped regions 122 and a laser heavily doped region 13 on the front surface of the silicon wafer 11 (refer to FIGS. 1 to 3).

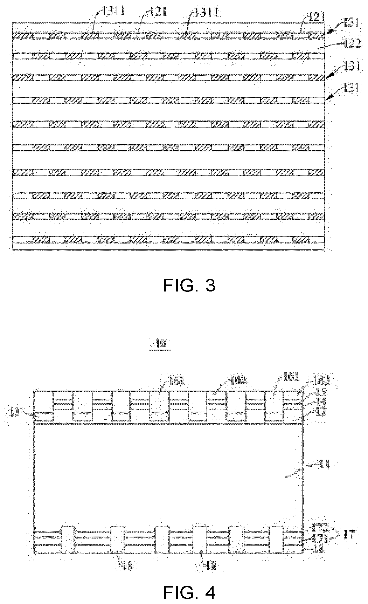

The laser heavily doped region 13 may include a plurality of doped layers 131 arranged at intervals in a preset direction; each doped layer 131 may include a plurality of doped regions 1311 arranged at intervals; the first lightly doped regions 121 may be located between the doped regions 1311 of each doped layer 131, and each second lightly doped region 122 may be located between two adjacent doped layers 131 (refer to FIGS. 2 and 3). Exemplarily, as shown in FIGS. 2 and 3, the preset direction is a longitudinal direction, the plurality of doped layers 131 are arranged at intervals in the longitudinal direction, and the doped regions 1311 of each doped layer 131 are arranged at intervals in a transverse direction. Exemplarily, the first lightly doped region 121, the second lightly doped region 122, and the laser heavily doped region 13 are optionally doped with phosphorus or boron.

The laser heavily doped region 13 may be a laser processed part, the first and second lightly doped regions 121, 122 may be parts which are not processed by laser, and the first lightly doped region 121 may be located between the doped regions 1311 of each set of doped layers 131. Compared with the solution that the doped regions 1311 are continuously arranged, in the embodiments of the present application, laser doped regions are relatively small, which may reduce damage of laser to the silicon wafer 11, and reduce surface compounding of the silicon wafer 11 and damage of the laser to a textured surface, thereby improving the cell efficiency.

Exemplarily, the silicon wafer 11 may have a resistivity of 0.1Ω*cm to 3.0Ω*cm.The silicon wafer 11 with the resistivity in this range facilitates an increase of the cell efficiency of the PERC solar cell 10. Optionally, the wafer 11 has a resistivity of 0.1Ω*cm, 0.5Ω*cm, 1Ω*cm, 1.5Ω*cm, 2Ω*cm, 2.5Ω*cm, or 3Ω*cm.

Optionally, the laser heavily doped region 13 and the first lightly doped region 121 may have a total area of S, and the area of the laser heavily doped region 13 and S may have a ratio of 1:10 to 9:10. It should be noted that the area of the laser heavily doped region 13 refers to the sum of the areas of all the doped regions 1311. The total area S refers to the total area of the plurality of doped layers 131 and the first lightly doped regions 121 between the doped regions 1311 of the plurality of doped layers 131.

The applicant finds through research that when the area of the laser heavily doped region 13 and S may have a ratio of 1:10 to 9:10, the cell efficiency may be improved better. Exemplarily, the area of the laser heavily doped region 13 and S may have a ratio of any one of 1:10, 1:5, 3:10, 2:5, 1:2, 3:5, 7:10, 4:5 and 9:10 or a range between any two therefrom. Exemplarily, the area of the laser heavily doped region 13 and S may have a ratio of 2:5 to 3:5.

Optionally, the doped regions 1311 of two adjacent doped layers 131 may be staggered (refer to FIG. 3). The applicant finds through research that such an arrangement may better improve the cell efficiency. It may be understood that the stagger means that the doped regions 1311 of two adjacent doped layers 131 may not be overlapped or may be partially overlapped, and the overlapped part is less than 50% of the length of the doped region 1311. It may be understood that the doped regions 1311 of two adjacent sets of doped layers 131 may be aligned (refer to FIG. 2).

Referring to FIG. 4, further embodiments of the present application provide a PERC solar cell 10, which may include: a PERC solar cell selective emitter 100 according to some embodiments of the present application, a positive electrode, a front passivation layer 14 on the surfaces of the first lightly doped region 121 and the second lightly doped region 122, and a front anti-reflective layer 15 on the surface of the front passivation layer 14.

The positive electrode may include first silver paste layers 161 on the surfaces of the laser heavily doped regions 13 and second silver paste layers 162 on the surface of the front anti-reflective layer 15 corresponding to the first lightly doped regions 121, and the second silver paste layers 162 are in electrical contact with the first silver paste layers 161.

The second silver paste layer 162 is in electrical contact with the first silver paste layer 161 to achieve effects of connection and current leading-out. Compared with the solution that the silver paste layer is in complete contact with the silicon wafer 11, in the embodiments of the present application, the second silver paste layer 162 is only in contact with the first silver paste layer 161 and not in contact with the silicon wafer 11, which results in low series resistance, thereby improving the cell efficiency.

Exemplarily, the front anti-reflective layer 15 may be a silicon nitride layer, and the front passivation layer may be a silicon dioxide layer.

The back surface of the PERC solar cell 10 may be further provided with a back passivation layer 17 and an aluminum back surface field 18, the back passivation layer 17 may be formed on the back surface of the silicon wafer 11, the back passivation layer 17 may be provided with a slot, and the aluminum back surface field 18 may be formed on the surface of the back passivation layer 17 and in the slot and in contact with the back surface of the silicon wafer 11. Optionally, the back passivation layer 17 includes a back silicon nitride layer 171 and a back aluminum oxide layer 172, the back aluminum oxide layer 172 is formed on the back surface of the silicon wafer 11, and the back silicon nitride layer 171 is formed on the surface of the back aluminum oxide layer 172.

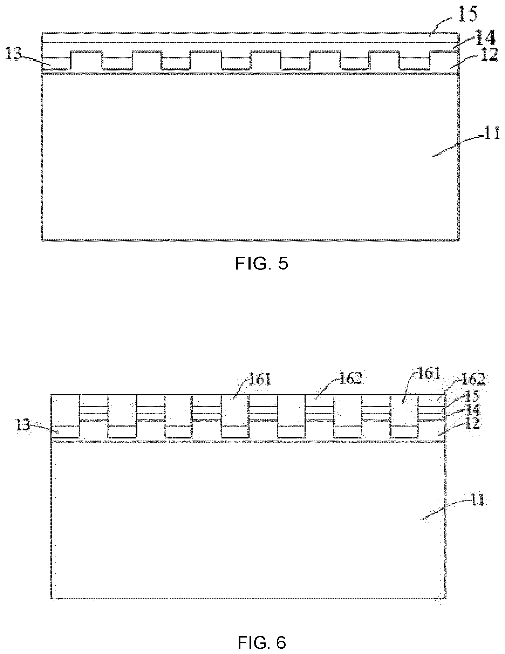

Still further embodiments of the present application provide a manufacturing method for a PERC solar cell 10 according to some embodiments of the present application, which may include:
S1: diffusing on the surface of the textured silicon wafer 11 to form a diffusion layer 12, and performing laser doping on the diffusion layer 12 to form the laser heavily doped region 13, regions of the diffusion layer 12 which are not subjected to laser doping being lightly doped regions, and the lightly doped regions including the first lightly doped region 121 and the second lightly doped region 122. The laser heavily doped region 13 may include the plurality of doped layers 131 arranged at intervals in the preset direction; each doped layer 131 may include the plurality of doped regions 1311 arranged at intervals; the first lightly doped regions 121 may be located between the doped regions 1311 of each doped layer 131, and each second lightly doped region 122 may be located between two adjacent doped layers 131 (refer to FIGS. 1 to 3).
S2: sequentially plating the surfaces of the laser heavily doped region 13 and the lightly doped region with the front passivation layer 14 and the front anti-reflective layer 15 (refer to FIG. 5).
S3: plating the surface of the front anti-reflective layer 15 corresponding to a laser heavily doped layer 131 region with the first silver paste layer 161, and burning through the front anti-reflective layer 15 and the front passivation layer 14, such that the first silver paste layer 161 is in contact with the laser heavily doped layer 131 region, and plating the surface of the front anti-reflective layer 15 corresponding to the first lightly doped region 121 with the second silver paste layer 162, the second silver paste layer 162 being in electrical contact with the first silver paste layer 161 (refer to FIG. 6).

The laser heavily doped region 13 of the PERC solar cell 10 may be a laser processed part, the first and second lightly doped regions 121, 122 may be parts which are not processed by laser, the first silver paste layer 161 may burn through the front anti-reflective layer 15 and the front passivation layer 14 to be in contact with the laser heavily doped region 13 to form good ohmic contact, the second silver paste layer 162 does not burn through the front anti-reflective layer 15 and the front passivation layer 14 to be formed on the surface of the front anti-reflective layer 15 corresponding to the first lightly doped region 121, and the second silver paste layer 162 is in electrical contact with the first silver paste layer 161 to achieve the effects of connection and current leading-out. Compared with the solution that the doped regions 1311 are continuously arranged, in the embodiments of the present application, the laser doped regions are relatively small, which may reduce damage of laser to the silicon wafer 11, thereby improving the cell efficiency. Compared with the solution that the silver paste layer is in complete contact with the silicon wafer 11, in the embodiments of the present application, the second silver paste layer 162 is only in contact with the first silver paste layer 161 and not in contact with the silicon wafer 11, which results in low series resistance, thereby improving the cell efficiency.

Exemplarily, the laser for laser doping may have a frequency of 10KHZ to 1,000KHZ and a band speed of 1,000m/h to 300,000m/h. Optionally, the laser has a frequency of 10KHZ, 30KHZ, 50KHZ, 100KHZ, 200KHZ, 400KHZ, 500KHZ, 800KHZ, or 1,000KHZ. Optionally, the laser has a band speed of any one of 1,000m/h, 3,000m/h, 5,000m/h, 8,000m/h, 10,000m/h, 30,000m/h, 50,000m/h, 80,000m/h, 100,000m/h, 200,000m/h, and 300,000m/h or a range between any two therefrom. It may be understood that the laser band speed refers to the length swept by the laser in unit time.

Optionally, paste of the first silver paste layer 161 contains 5wt% to 10wt% of oxide, paste of the second silver paste layer 162 contains 0wt% to 2wt% of oxide, and the oxide includes at least one of PbO, B₂O₃, SiO₂, BiO₃, and ZnO.

The paste of the first silver paste layer 161 contains 5wt% to 10wt% of oxide which may include at least one of PbO, B₂O₃, SiO₂, BiO₃, and ZnO, and the oxide may burn through the front passivation layer 14 and the front anti-reflective layer 15 during sintering, such that the passivation effect is reduced; the front passivation layer 14 and the front anti-reflective layer 15 are burnt through by the oxide, such that the first silver paste layer 161 is in contact with the laser heavily doped region 13, thus leading out the current. Paste of the second silver paste layer 162 may contain a small amount of oxide or may not contain the oxide, and the second silver paste layer 162 does not damage the front passivation layer 14 and the front anti-reflective layer 15, thus not only achieving the effects of connection and current leading-out, but also achieving the effect of increasing the open circuit voltage.

Exemplarily, the paste of the first silver paste layer 161 may contain 5wt%, 6wt%, 7wt%, 8wt%, 9wt%, or 10wt% of oxide. Exemplarily, the paste of the second silver paste layer 162 may contain 0.1wt%, 0.3wt%, 0.5wt%, 0.7wt%, 1wt%, 1.2wt%, 1.5wt%, 1.7wt%, or 2wt% of oxide. Optionally, the paste of the second silver paste layer 162 may not contain the above-mentioned oxide.

Optionally, the paste of the first silver paste layer 161 and the paste of the second silver paste layer 162 may each contain 60wt% to 90wt% of silver powder. The paste of the first silver paste layer 161 and the second silver paste layer 162 has high silver powder content, thus achieving a good conductive effect. Exemplarily, the paste in the first silver paste layer 161 may contain 60wt%, 65wt%, 70wt%, 75wt%, 80wt%, 85wt%, or 90wt% of silver powder. Exemplarily, the paste in the second silver paste layer 162 may contain 60wt%, 65wt%, 70wt%, 75wt%, 80wt%, 85wt%, or 90wt% of silver powder.

Exemplarily, the silver powder may have a particle size of 0.1µm to 4µm. The silver powder with the particle size in this range facilitates adherence to the surface of the laser heavily doped layer 131 region and the surface of the first lightly doped region 121. Optionally, the silver powder has a particle size of 0.1µm 0.3µm, 0.5µm, 0.8µm, 1µm, 2µm, 3µm, or 4µm.

The paste of the first silver paste layer 161 and the paste of the second silver paste layer 162 may further contain organic carriers, and the organic carriers may include a thickener, a solvent, a surfactant, and a thixotropic agent; exemplarily, the paste of the first silver paste layer 161 and the paste of the second silver paste layer 162 may have 10wt% to 30wt% of organic carriers.

The PERC solar cell selective emitter 100, the PERC solar cell 10, and the manufacturing method therefor according to the present application are further described in detail below with reference to embodiments.

### Example 1

The present embodiment provides a PERC solar cell, and a manufacturing process therefor may include:
diffusing on the surface of a textured silicon wafer to form a diffusion layer, and performing laser doping on the diffusion layer to form a laser heavily doped region, regions of the diffusion layer which are not subjected to laser doping being lightly doped regions, the lightly doped regions including a first lightly doped region and a second lightly doped region, the laser heavily doped region including a plurality of doped layers arranged at intervals in the longitudinal direction, each doped layer including a plurality of doped regions arranged at intervals in the transverse direction, the first lightly doped regions being located between the doped regions of each doped layer, and each second lightly doped region being located between two adjacent doped layers. The doped regions of two adjacent sets of doped layers are aligned, the laser heavily doped region and the first lightly doped region have a total area of S, and the area of the laser heavily doped region and S have a ratio of 1:2.

The surfaces of the laser heavily doped region and the lightly doped region are sequentially plated with a front passivation layer and a front anti-reflective layer.

The surface of the front anti-reflective layer corresponding to a laser heavily doped layer region is plated with a first silver paste layer, and the front anti-reflective layer and the front passivation layer are burnt through, such that the first silver paste layer is in contact with the laser heavily doped region; and the surface of the front anti-reflective layer corresponding to the first lightly doped region is plated with a second silver paste layer, the second silver paste layer being in electrical contact with the first silver paste layer.

A back passivation layer is formed on the back surface of the silicon wafer, the back passivation layer is slotted, an aluminum back surface field is formed on the surface of the back passivation layer and in the slot, the aluminum back surface field is in contact with the back surface of the silicon wafer, and the formed PERC solar cell is shown in FIG. 4.

### Example 2

The present embodiment provides a PERC solar cell, and a manufacturing process thereof is substantially the same as the manufacturing process in Example 1 except that the doped regions of two adjacent sets of doped layers in the present embodiment are staggered (refer to FIG. 3).

### Example 3

The present embodiment provides a PERC solar cell, and a manufacturing process thereof is substantially the same as the manufacturing process in Example 1 except that the area of the laser heavily doped region and S have a different ratio which is 1:9.

### Example 4

The present embodiment provides a PERC solar cell, and a manufacturing process thereof is substantially the same as the manufacturing process in Example 1 except that the area of the laser heavily doped region and S have a different ratio which is 2:3.

### Example 5

The present embodiment provides a PERC solar cell, and a manufacturing process thereof is substantially the same as the manufacturing process in Example 1 except that the area of the laser heavily doped region and S have a different ratio which is 0.5:9.5.

### Comparative Example 1

The comparative example provides a PERC solar cell, and a manufacturing process therefor includes:
diffusing on the surface of a textured silicon wafer to form a diffusion layer, and performing laser doping on the diffusion layer to form a laser heavily doped region, regions of the diffusion layer which are not subjected to laser doping being lightly doped regions, the laser heavily doped region including a plurality of doped layers which are arranged at intervals in the vertical direction, and each doped layer being composed of continuously arranged doped regions.

The surfaces of the laser heavily doped region and the lightly doped region are sequentially plated with a front passivation layer and a front anti-reflective layer.

The surface of the front anti-reflective layer corresponding to the laser heavily doped region is plated with a first silver paste layer, and the front anti-reflective layer and the front passivation layer are burnt through, such that the first silver paste layer is in contact with the laser heavily doped region. The first silver paste layer has same paste as the first silver paste layer in the first embodiment.

A back passivation layer is formed on the back surface of the silicon wafer, the back passivation layer is slotted, an aluminum back surface field is formed on the surface of the back passivation layer and in the slot, and the aluminum back surface field is in contact with the back surface of the silicon wafer.

### Test Example 1

Open circuit voltages, short circuit currents, filling factors and conversion efficiencies of the PERC solar cells 10 manufactured according to Example 1-Example 5 and Comparative Example 1 were tested at 25°C under AM 1.5 and 1 standard sun using a halm online I-V test system, and results are shown in table 1.

**Table 1. Performance test results of PERC solar cells 10 of Example 1-Example 5 and Comparative Example 1**

| | Open circuit voltage (Voc)/V | Short circuit current (Isc)/A | Filling factor (FF)/% | Conversion efficiency (Eff)/% |
|---|---|---|---|---|
| Example 1 | 0.6815 | 9.882 | 82.28 | 22.65 |
| Example 2 | 0.6816 | 9.883 | 82.35 | 22.68 |
| Example 3 | 0.6828 | 9.889 | 82.01 | 22.60 |
| Example 4 | 0.6805 | 9.878 | 82.38 | 22.62 |
| Example 5 | 0.6831 | 9.892 | 81.87 | 22.56 |
| Comparative Example 1 | 0.6796 | 9.854 | 82.04 | 22.57 |

From the results of table 1, the PERC solar cell according to Example 1 has a better open circuit voltage, short circuit current, filling factor, and cell efficiency than the PERC solar cell in Comparative Example 1. After comparison of the results of Examples 1-4 and Example 5, the conversion efficiencies of the PERC solar cells according to Examples 1-4 are better than the conversion efficiency of the PERC solar cell according to Example 5, which shows that the ratios of the area of the laser heavily doped region to S in Examples 1-4 of the present application better facilitate an improvement of the conversion efficiency of the PERC solar cell.

The above description is only specific embodiments of the present application and is not intended to limit the present application, and various modifications and changes may be made to the present application by those skilled in the art. Any modification, equivalent replacement, or improvement made within the spirit and principle of the present application shall be included in the protection scope of the present application.

### Industrial applicability

The present application provides the PERC solar cell selective emitter, the PERC solar cell and the manufacturing method therefor. The selective emitter includes the silicon wafer, the first lightly doped regions, the second lightly doped regions and the laser heavily doped region; the laser heavily doped region includes the plurality of doped layers; each doped layer includes the plurality of doped regions arranged at intervals; the first lightly doped regions are located between the doped regions of each doped layer, and each second lightly doped region is located between two adjacent doped layers. The PERC solar cell includes the selective emitter, the front anti-reflective layer on the surface of the front passivation layer, and the positive electrode. The positive electrode includes the first silver paste layers on the surfaces of the laser heavily doped regions and the second silver paste layers on the surface of the front anti-reflective layer corresponding to the first lightly doped regions, and the second silver paste layers are in electrical contact with the first silver paste layers. Damage of the laser to the silicon wafers is reduced, compounding in silver paste areas is reduced, the open circuit voltage is increased, and the cell efficiency is improved.

Furthermore, it may be understood that the PERC solar cell selective emitter, the PERC solar cell and the manufacturing method therefor according to the present application are reproducible and may be used in various industrial applications. For example, the PERC solar cell selective emitter, the PERC solar cell and the manufacturing method therefor according to the present application may be applied to the field of solar cells.

## Claims

1. A PERC solar cell selective emitter, comprising:
a silicon wafer; and
first lightly doped regions, second lightly doped regions and a laser heavily doped region on a front surface of the silicon wafer, wherein the laser heavily doped region comprises a plurality of doped layers arranged at intervals in a preset direction; each of the doped layers comprises a plurality of doped regions arranged at intervals; the first lightly doped regions are located between the doped regions of each of the doped layers, and each of the second lightly doped regions is located between two adjacent doped layers.

2. The PERC solar cell selective emitter according to claim 1, wherein the laser heavily doped region and the first lightly doped regions have a total area of S, and an area of the laser heavily doped region and S have a ratio of 1:10 to 9:10.

3. The PERC solar cell selective emitter according to claim 2, wherein the area of the laser heavily doped region and S have a ratio of 2:5 to 3:5.

4. The PERC solar cell selective emitter according to any one of claims 1 to 3, wherein the doped regions of two adjacent doped layers are staggered.

5. The PERC solar cell selective emitter according to any one of claims 1 to 3, wherein the silicon wafer has a resistivity of 0.1Ω*cm to 3.0Ω*cm.

6. A PERC solar cell, comprising: the PERC solar cell selective emitter according to any one of claims 1 to 5;
a front passivation layer on surfaces of the first lightly doped regions and the second lightly doped regions;
a front anti-reflective layer on a surface of the front passivation layer; and
a positive electrode, comprising a first silver paste layer on a surface of the laser heavily doped region and a second silver paste layer on a surface of the front anti-reflective layer corresponding to the first lightly doped regions, wherein the second silver paste layer is in electrical contact with the first silver paste layer.

7. The PERC solar cell according to claim 6, wherein a paste of the first silver paste layer and a paste of the second silver paste layer contain an organic carrier, and the organic carrier comprises a thickener, a solvent, a surfactant, and a thixotropic agent.

8. The PERC solar cell according to claim 7, wherein the paste of the first silver paste layer and the paste of the second silver paste layer contain 10wt% to 30wt% of the organic carrier.

9. The PERC solar cell according to any one of claims 6 to 8, wherein the front anti-reflective layer is a silicon nitride layer, and the front passivation layer is a silicon dioxide layer.

10. The PERC solar cell according to any one of claims 6 to 9, wherein a back surface of the PERC solar cell is further provided with a back passivation layer and an aluminum back surface field, the back passivation layer is formed on a back surface of the silicon wafer, the back passivation layer is provided with a slot, and the aluminum back surface field is formed on a surface of the back passivation layer and in the slot and in contact with the back surface of the silicon wafer.

11. A method for manufacturing the PERC solar cell according to claim 6, comprising:
diffusing on a surface of a textured silicon wafer to form a diffusion layer, and performing laser doping on the diffusion layer to form the laser heavily doped region, regions of the diffusion layer which are not subjected to the laser doping are lightly doped regions, and the lightly doped regions comprising the first lightly doped regions and the second lightly doped regions;
sequentially plating surfaces of the laser heavily doped region and the lightly doped regions with the front passivation layer and the front anti-reflective layer; and
plating a surface of the front anti-reflective layer corresponding to the laser heavily doped region with the first silver paste layer, and burning through the front anti-reflective layer and the front passivation layer, such that the first silver paste layer is in contact with the laser heavily doped region, and plating a surface of the front anti-reflective layer corresponding to the first lightly doped regions with the second silver paste layer, the second silver paste layer being in electrical contact with the first silver paste layer.

12. The method according to claim 11, wherein a back passivation layer is formed on a back surface of the silicon wafer, the back passivation layer is slotted, an aluminum back surface field is formed on a surface of the back passivation layer and in the slot, and the aluminum back surface field is in contact with the back surface of the silicon wafer.

13. The method according to claim 11 or 12, wherein a paste of the first silver paste layer contains 5wt% to 10wt% of oxide, a paste of the second silver paste layer contains 0wt% to 2wt% of oxide, and the oxide comprises at least one of PbO, B₂O₃, SiO₂, BiO₃, and ZnO.

14. The method according to claim 13, wherein the paste of the first silver paste layer and the paste of the second silver paste layer each contain 60wt% to 90wt% of silver powder.

15. The method according to claim 14, wherein the silver powder has a particle size of 0.1µm to 4µm.
